# EUROPEAN PATENT SPECIFICATION

(11) **EP 2 543 081 B1**
(45) Date of publication and mention of the grant of the patent: **29.04.2020**
(21) Application number: 10707801.6
(22) Date of filing: 05.03.2010
(51) Int. Cl.: H01L 31/18, H01L 31/042

(54) **METHOD AND APPARATUS FOR FABRICATING MONOLITHICALLY-INTEGRATED PHOTOVOLTAIC MODULES AND PHOTOVOLTAIC MODULE**
HERSTELLUNGSVERFAHREN UND VORRICHTUNG ZUR HERSTELLUNG VON MONOLITISCH-INTEGRIERTEN PHOTOVOLTAISCHEN MODULEN UND PHOTOVOLTAISCHES MODUL
MÉTHODE ET APPAREIL POUR LA FABRICATION DE MODULES PHOTOVOLTAÏQUES MONOLITHIQUEMENT INTÉGRÉS ET MODULE PHOTOVOLTAÏQUE

(43) Date of publication of application: 09.01.2013
(73) Proprietor: Flisom AG, 8155 Niederhasli (CH)
(72) Inventor: STUDER, Thomas, 11500 El Puerto de Santa Maria (ES); KAELIN, Marc, 8037 Zürich (CH); BUDDE, Felix, 70499 Stuttgart (DE); RUDMANN, Dominik, 4054 Basel (CH)
(86) International application number: PCT/CH2010/000057
(87) International publication number: WO 2011/106902

(56) References cited:
- WO-A1-2009/029901
- WO-A2-2008/042682
- JP-A- 8 330 232
- US-A1- 2009 291 231

## Description

The invention relates to a method and apparatus for fabricating monolithically-integrated photovoltaic modules, according to claims 1 and 9. The invention also relates to a photovoltaic module according to claim 10. The method comprises the steps of forming a film layer on a deposition area such that at least a portion of said film layer constitutes a photoactive layer, applying a patterning scheme for dividing said film layer into area sections and providing electrically interconnected components, each comprising at least one of said area sections. The photovoltaic module comprises at least one film layer, said film layer being divided into area sections, and electrically interconnected components, each comprising at least one of said area sections. More particularly, the invention relates to the fabrication of photovoltaic modules with a film layer formed by, but not limited to, an ABC₂ material, wherein A represents elements in group 11 of the periodic table of chemical elements as defined by the International Union of Pure and Applied Chemistry including Cu or Ag, B represents elements in group 13 of the periodic table including In, Ga, or Al, and C represents elements in group 16 of the periodic table including S, Se, or Te.

Thin-film photovoltaic cells such as Cu(In,Ga)Se₂- (CIGS-) or CdTe-based photovoltaic cells show a high potential for cheaper solar electricity, lower energy payback time, and improved life cycle impact as compared to traditional wafer-based silicon photovoltaic cells. These advantages originate mostly from three factors: First, thin-film absorbers can absorb solar radiation within very thin layers of the order of micrometers. Second, thin-film photovoltaic modules can be produced in-line and in large sizes with a high degree of automation and thus little labor cost. Third, thin-film photovoltaic cells can be monolithically integrated to photovoltaic modules.

Such a photovoltaic module essentially consists of an array of interconnected photovoltaic cells and optional additional devices such as bypass diodes, directly or indirectly connected to current collectors (busbars) and on, or in between, supporting structures for protective and/or mechanical reasons. The term "monolithical integration" means that several photovoltaic cells on the same substrate can be interconnected during manufacturing to form a module on that substrate, whereas non-monolithically-integrated modules (such as wafer-based modules) consist of individual photovoltaic cells requiring manual interconnection after cell manufacturing.

For the sake of monolithical integration, some or all of the photovoltaic module films need to be patterned in one or several processing steps at one or different stages of the manufacturing process, either during or after the deposition of individual layers or during or after deposition of groups of layers,see for example M. Powalla and D. Bonnet, Advances in OptoElectronics, vol. 2007, Article ID 97545, 2007. Patterning is usually achieved by applying a predefined patterning scheme in order to divide the photoactive film layer and/or auxiliary layers, e.g. back contact, absorber, buffer, window, and front contact layers, in several area sections for defining location, size, and shape of module elements, in particular photovoltaic cells. Patterning is further performed such that at least two interconnects can be formed to each module element - typically to each element's plus and minus pole, respectively - such that the element is connected either in parallel or in series to other, typically adjacent, module elements or to the busbar. Common patterning techniques are scribing methods such as mechanical or laser scribing of one or several layers at a time, but also shadowing, lithography, or other methods are used, as described for example in WO 03/061013 A1. Monolithic integration can also be achieved by structuring certain layers during their deposition e.g. by using shadow masks.

Each photovoltaic cell has a maximum power point (MPP), which denotes the condition of a cell, under which it delivers the highest amount of electrical power under given illumination conditions. When photovoltaic cells consist of material with inhomogeneous optoelectronic properties, the following problems may arise: A large photovoltaic cell can be thought of as a submodule consisting of the parallel connection of smaller cells which together cover the same area as the large cell. As soon as the voltage across this submodule exceeds the diode threshold voltage of one of the smaller cells, the current produced by the other cells starts to flow back through that cell with the lowest diode threshold voltage. Hence, cells with a high MPP voltage cannot be operated at that voltage without losing too much current due to current reversal. In other words, the MPP voltage of the submodule is dragged towards the MPP voltage of the cell with the lowest diode threshold voltage. If the differences in MPP voltage between the small cells are large, many cells are operated below their MPP, thereby reducing submodule efficiency. In the extreme case, owing to the presence of one weak cell, all other cells connected in parallel may operate at non-optimum efficiency in order to operate the submodule at its MPP. Therefore, it is highly desirable that any photovoltaic cell possess homogeneous optoelectronic properties across its area in order to deliver maximum electrical power.

Since a real cell is typically not totally homogeneous in its optoelectronic properties and also shading of one or more cells may occur, the current difference will flow through the weakest spot of the weakest cell or shaded cell, where the local reverse-breakdown voltage is lowest. In that weak spot, a very large local current density may occur and induce permanent cell damage due to overheating. In order to avoid a resulting degradation of the whole photoactive area of the photovoltaic module, a reverse bias protection can be employed, e.g. in the form of a bypass diode: When a negative bias voltage builds up across a photovoltaic cell and the threshold voltage of the bypass diode is exceeded, then reverse current can flow through the bypass diode instead of through the weak spot of the weakest or shaded cell, provided that the threshold voltage of the bypass diode is lower than the reverse-breakdown voltage of the photovoltaic cell's weak spot.

Bypass diodes can be incorporated into monolithically-integrated thin-film modules by connecting photovoltaic cells anti-parallel, i.e. with their polarities reversed. The diodes can be formed over single cells, lower- and higher-level submodules consisting of several cells, and also over the whole module, to another cell or to a string of other cells. These diodes traditionally have been discrete components attached to the photovoltaic module by soldering or similar techniques. Another technique for creating integrated diodes includes adding additional layers non-monolithically onto the bottom or surface of the cell, as described for example in U.S. patent no. US 6,635,507. A diode can also be formed by monolithic integration into the module as described in patent no. US 6,690,041. These integration techniques of a diode generally require a number of additional processing steps and/or material to be applied on the device. Thus, one of their disadvantages lies in an increase of complexity and costs for device manufacturing.

The electrical performance of each of the described components of a photovoltaic module, i.e. photovoltaic cells, submodules, bypass diodes, etc., are ordinarily described by one or several characteristic values of their respective current-voltage characteristic curves. For instance, the open-circuit voltage and/or the current/voltage at the maximum power point are often quoted with respect to photovoltaic cell or photovoltaic submodule properties. A diode behavior is generally well described by the value of the threshold voltage. In the special case of a Zener diode, the reverse breakdown voltage is a characteristic value.

WO 2008/042682 A2 describes a thin film photovoltaic module, in which an undesired non-uniformity of the film layer shall be compensated. To this end, the module is divided into single photovoltaic cells along the direction, in which the non-uniformity of the film layer occurs. According to another embodiment, such a division can also be carried out within several submodules of the module, wherein corresponding submodules in an area zone of a given film-layer uniformity are series connected to a set of submodules, and these different sets of submodules are mutually connected in parallel. In another embodiment, protect diodes are fabricated on the film layer as a part of the lithographic process during which adjacent photovoltaic cells are connected. The protect diodes are arranged in parallel to the direction, in which the film layer is divided into single photovoltaic cells, such that they are fabricated from the same film layer properties as the photovoltaic cells. This has the disadvantage that deviating film properties, which may be required for a reliable functionality of these additional components, are not inherently accounted for, and additional processing steps may be required to improve their performance.

It is an object of the present invention to avoid at least one of the above mentioned disadvantages and to provide a method and/or an apparatus which allows the fabrication of monolithically-integrated photovoltaic modules comprising interconnected photovoltaic cells with requirement-matched photovoltaic properties, in particular such that deviations of the voltage and/or current at the maximum power point of said photovoltaic cells are substantially reduced and/or the power output of the total available photoactive area is optimized. It is another object of the invention to provide a method and/or an apparatus for monolithically integrating further components, such as bypass diodes and/or resistances, in a photovoltaic module, wherein the fabrication process and/or the structural composition of such a module is simplified and suitable film properties for the further components are accounted for. It is a further object of the invention to allow the fabrication of a photovoltaic module at reduced production costs and/or to provide a photovoltaic module exhibiting at least one of the above-mentioned properties.

At least one of the above objects is achieved with a method comprising the features of patent claim 1, as well as an apparatus comprising the features of patent claim 9, as well as a photovoltaic module comprising the features of patent claim 10. Advantageous embodiments of the invention are defined in the dependent claims.

In a method for fabricating monolithically-integrated photovoltaic modules, the invention suggests that at least one compositional and/or structural property, in particular material percentage composition and/or thickness, of said film layer is varied over said deposition area and said patterning scheme is applied in such a way that at least one of said film layer variations in at least one of said area sections is reduced with respect to the corresponding film layer variation over said deposition area. In this way, at least two of said area sections are provided with substantially differing compositional and/or structural properties such that at least two of said components exhibit substantially differing current-voltage characteristics. Furthermore, said at least two components are interconnected in parallel for exploiting at least one advantage of said differing current-voltage characteristics:
One of the advantages may arise from the possibility of voltage matching of at least two components consisting of single photovoltaic cells or submodules, each comprising several photovoltaic cells in a series connection, wherein said different current-voltage characteristics may comprise a different current value at a substantially equal voltage value at the maximum power point and/or a different open circuit voltage of these components. Another advantage may include the possibility of a simplified monolithic integration process of additional components, in particular bypass diodes, resistors and/or Zener diodes, wherein said different current-voltage characteristics may comprise a different diode threshold voltage and/or a different reverse breakdown voltage.

Advantageously, said current-voltage characteristics of at least two of said components may differ by a factor of at least 2 percent, more preferred by a factor of at least 5 percent, and most preferred by a factor of at least 10 percent.

Said variations of at least one compositional and/or structural property of said film layer may occur or be imposed over said deposition area. In particular, said compositional and/or structural and/or voltage properties may comprise the material percentage composition and/or the thickness of said film layer. In this way, film patterning processes may be correlated with spatial variations of film properties such as electronic, compositional, optoelectronic, or structural properties.

According to one embodiment, this correlation of patterning with spatial variations of film properties may be exploited to tailor photovoltaic cell patterns and geometries such that each individual photovoltaic cell exhibits comparable photovoltaic properties and consequently good current and voltage matching can be achieved. In particular, the lifetime electricity generation of the module may be maximized and/or the temporal power output profile of the module may be optimized, while at the same time conditions and restrictions on thin-film deposition processes can be relaxed and/or material utilization yield during the deposition process may be improved. According to another embodiment, said correlation of patterning with spatial film variations may be exploited for creating further tailored units such as bypass diodes, resistances, or conductors. The aforementioned benefits may therefore advantageously contribute to a decrease of the cost of solar electricity generation. Preferably, such a tailoring of photovoltaic cell patterns may be achieved by applying said patterning scheme in such a way that at least one geometrical property, in particular the size and/or shape and/or orientation and/or areal number, of said area sections is varied in dependence of at least one of said film layer variations. In this way, single photovoltaic cells and/or submodules, each comprising several photovoltaic cells in a series connection, may be provided with a substantially equal voltage value at their maximum power point.

Advantageously, said patterning scheme may be applied in such a way as to subdivide said deposition area into area zones with different compositional and/or structural properties of said film layer, at least one of said area zones comprising area sections with essentially the same compositional and/or structural properties of said film layer. At least one of said components in at least one area zone may be provided by a submodule, each comprising several single photovoltaic cells in a series connection.

In order to allow matching of said patterning scheme to specific requirements, said method may comprise the further steps of determining at least one of said film layer variations and adjusting said patterning scheme in dependence thereof. In particular, this step may comprise measuring of local properties of said film layer by means of non-destructive tests. Additionally or alternatively, said determination of at least one of said film layer variations may be based on empirical values and/or based on theoretical calculations and/or performed by testing of prior batches and/or by testing of periodic zones of said film layer, in particular of sacrificial zones, etc.

To achieve a more uniform distribution of said compositional and/or structural and/or voltage property on said area sections of said film layer, at least one of said area sections with a larger size may be arranged in a region where said film layer variations are small as compared to at least one of said area sections with a smaller size that is arranged in a region where the corresponding film layer variations are larger.

Advantageously, in particular for creating the desired photovoltaic properties on said area sections, said patterning scheme may be applied such that the local single photovoltaic cell current-voltage characteristics in at least one submodule is reduced with respect to local photovoltaic cell current-voltage characteristics of another submodule by a factor of at least 2 percent, more preferred by a factor of at least 5 percent and most preferred by a factor of at least 10 percent.

Advantageously, said application of said patterning scheme may subdivide the photovoltaic module into zones of improved homogeneity of photovoltaic properties such that particularly the voltage at the maximum power point (MPP) in the predominant zone is increased by at least the open circuit voltage of a photovoltaic cell thus created in the zone of lower open circuit voltage properties. Thereby, the homogeneity improvement permits operating the entire zone closer to the local MPP conditions and thus improves efficiency.

Preferably, said forming of a film layer comprises the steps of evaporating and depositing material on said deposition area from at least one material source, wherein said deposition area is moved with respect to said material source and said varying of at least one compositional and/or structural property of said film layer is carried out transverse to the respective moving direction. Thus, a continuous manufacturing process may be provided by varying said compositional and/or structural property in at least one or two dimensions and by moving said deposition area in a different direction. Such a method may be integrated in a so called roll-to-roll manufacturing technology for allowing continuous deposition of said film layer at high speeds under rolling of said deposition area. For allowing said rolling, said deposition area may be constituted by a plastic substrate.

In order to account for said transverse variation of said film layer properties, at least two, more preferred at least three, of said area sections may be disposed in a transverse direction with respect to said moving direction. In order to account for an inhomogeneous deposition rate along said transverse direction, in particular for a smaller variation of deposed material at a center portion, area sections with a larger size may be provided at a center portion of said deposition area with respect to said transverse direction as compared to area sections located at a side portion. According to a specific embodiment, said area sections at said center portion may cover at least two times, more preferred at least three times, more space in that transverse direction as compared to said area sections at said side portion.

Preferably, said forming of a film layer comprises evaporating and depositing materials on said deposition area from separated material sources, wherein the deposition rate of at least one of said sources is varied over said deposition area such that said varying of compositional properties comprises varying of a percentage composition and/or an absolute quantity of at least one of said deposited materials. In this way, a large variety of possible film layer variations may be achievable, since each source may be manipulated individually and also the relative positioning of the sources may be available as an adjustable parameter.

Said at least one source may be a point source or a linear source, wherein also sources of any other shape or nature are conceivable. In particular, said film variations may be produced by an inhomogeneous deposition profile of said source with respect to said deposition area, which results in variations of the deposition rate on said deposition area. More preferred, the local deposition rate on said deposition area may vary with distance and angle from the part of said source or sources at which material is leaving the source or sources. In particular, said local deposition rates may vary from said source or sources by a Lambert-cosine law or with a similar behavior. Thus in an advantageous embodiment of the method, deposition-source profiles may be adapted and correlated with suitable cell structuring patterns, such as to improve the optoelectronic properties of photovoltaic cells, bypass diodes, resistances, Zener diodes or conductors.

Moreover, means to control deposition, in particular shielding means and/or masking means and/or material guiding means, are applied on or in the vicinity of said material source or sources to control at least one of said film layer variations. Thus, adequate control of said deposition rate combined with appropriate application of said patterning scheme may be used to optimize the output power of said module, in particular with respect to full illumination conditions and/or lifetime performance. Alternatively or additionally, the useful deposition width on said deposition area may be optimized thereby. Alternatively or additionally, optoelectronic properties on at least one specific position of said film layer may be altered to provide additional components such as bypass-diodes and/or resistances and/or Zener diodes.

More generally, at least one of said compositional and/or structural properties of said film layer may be varied to provide at least one bypass-diode and/or resistance and/or Zener diode comprising at least a portion of said film layer on at least one of said area sections after application of said patterning scheme. In particular, said film layer may be altered on one or more regions such that degraded photovoltaic conversion properties are generated in these regions in which said additional components may be provided. For instance, at least one of said properties in at least one of said area sections may be altered such that a lower or a comparatively negligible photocurrent may be generated in this area section, or substantially no photocurrent at all. For instance, said diodes may be placed in a zone where the material composition deposited on said deposition area in essence does not generate a photocurrent. A resulting photovoltaic module may for example comprise several series-connected submodules, which in turn may consist of one or several parallel strings of series connected cells. Different strings may comprise different numbers of cells with individually designed sizes and/or shapes, and some or all of these strings may have properties resulting in reverse bias protection and bypass paths. Preferably, at least one diode is connected so as to block reverse current flow through the module, thereby providing a blocking diode . Preferably, said diodes are placed in zones in which said property variations of said film layer allow a small threshold voltage of said diodes.

Applying said patterning scheme may enable the production of varieties of submodules that may include said diodes. Said diodes may be formed in such a way that they are connected anti-parallel to parts of the module and/or submodule for reverse bypass protection. The bypass protection may be advantageous when at least one parallel submodule produces less energy than another submodule in the parallel assembly.

Said patterning scheme may therefore be used to produce submodules of matched voltage at MPP. Said submodules may contain a variety and a combination of series-connected cells, tandem cells, and/or multijunction cells. Matched MPP voltage may be advantageous when connecting submodules in parallel. When differing submodules are connected in parallel, the most powerful submodule of the parallel submodule circuit may be used as a guideline to form less powerful submodules whose MPP voltage is equal to or slightly greater than that of the most powerful submodule. The MPP voltage excess of the less powerful submodules as compared to the most powerful submodule may be capped by the open circuit voltage of one of its series-connected cells.

Furthermore, said patterning scheme may be used to form one or several current producing submodules that exhibit a Zener-barrier reverse breakdown property or similar behavior, thereby avoiding reverse breakdown damage to the module.

According to a specific embodiment of the method, simple deposition sources with a low degree of sophistication may be used to deposit thin-film material onto wide substrates. Resulting spatial variations of film properties may then be tolerated in that they do not give rise to module performance losses as compared to prior art devices.

The method is particularly suited for a film layer that is formed by, but not limited to, an ABC₂ material, wherein A represents Cu or Ag, B represents group 13 materials of the periodic table of elements as defined by the International Union of Pure and Applied Chemistry, including in particular In, Ga, or Al, and C represents S, Se, or Te. For instance, said film layer may be formed of Cu(In,Ga)Se₂ which is particularly suited for the implementation of this method. However, also other materials are conceivable such as CdTe-layers.

For a film layer formed by said ABC₂ material the deposition rate and distribution may be varied spatially so that in said area sections the material thickness deviates in at least two of said area sections by at least 5 percent and/or at most 30 percent, preferably at most 20 percent. Additionally or alternatively, the compositional ratio of Cu to group 13 material of the periodic table of chemical elements as defined by the International Union of Pure and Applied Chemistry may range from 0.6 to 0.9.

Said application of a patterning scheme may be achieved by mechanical scribing or laser scribing. Application of any other adequate means is also conceivable. Said application of a patterning scheme may be executed between two or several successive production steps, in particular between successive deposition of various layers. Said application of a patterning scheme may also be executed after deposition of all layers. Alternatively, a formation of interconnections and/or insulation may be achieved by deposition of various materials, such as contact grids and/or polymers, wherein further materials are also conceivable. In particular, said patterning may result in interconnected cells, submodules with several cells, and/or diodes.

According to a further aspect of the invention, an apparatus for the fabrication of monolithically-integrated photovoltaic modules is provided, said apparatus being defined in claim 10 and comprising at least one evaporation source that is adapted to deposit a film layer with at least one compositional and/or structural property varying over said deposition area and a patterning means that is adapted to divide said film layer into at least two of said area sections with substantially differing compositional and/or structural properties, such that at least two of said components exhibit substantially differing current-voltage characteristics. Furthermore, said apparatus is adapted to interconnect said at least two components in parallel.

Advantageously, said apparatus may in particular be adapted for a variation of the material percentage composition and/or the thickness of said film layer. According to a specific embodiment, said sources may comprise at least one of Cu, Ag, In, Ga, Al, S, Se and Te sources. According to the invention, said apparatus further comprises means to control deposition, in particular shielding means and/or masking means and/or material guiding means, for at least one of said material sources in order to control at least one of said film layer variations.

Preferably, said apparatus is in particular suited for execution of the above described method and may further comprise at least one additional appropriate means known in the art per se for conducting various steps of this method.

According to another aspect of the invention, a photovoltaic module as defined in claim 10 is provided comprising at least one film layer divided into electrically interconnected area sections, wherein at least a portion of said film layer constitutes a photoactive layer. The module further comprises electrically interconnected components each comprising at least one of said area sections. At least two of said area sections of said film layer are provided with substantially differing compositional and/or structural properties, such that at least two of said components exhibit substantially differing current-voltage characteristics. Said at least two components are interconnected in parallel for exploiting at least one of the advantages arising from said differing current-voltage characteristics. Thus, photovoltaic properties may be improved in such a module, in particular according to the above described manner. Furthermore, an implementation of additional components, such as diodes and/or resistances may be provided, in particular according to the above described manner. Thus, a bypass diode and/or resistance comprising at least a portion of said film layer may be provided by at least one of said components. In particular, said area sections may vary in their material percentage composition and/or thickness of said film layer.

Advantageously, said film layer may be divided into area zones with different compositional and/or structural properties of said film layer, at least one of said area zones comprising area sections with essentially the same compositional and/or structural properties of said film layer, and at least one of said components is provided by a submodule comprising a series connection of photovoltaic cells each comprising one of said area sections in said at least one area zone. Furthermore, at least two of said area sections may be provided with a different geometrical property comprising at least one of size, shape, orientation and areal number.

Preferably, such a photovoltaic module may exhibit advantageous performance properties according to which the voltage and/or current at the maximum power point (MPP) of said at least two photovoltaic cells and/or submodules may differ. Alternatively or additionally, this may be achieved if at least one of said area sections with a smaller areal size is provided more closely to a side portion of said photoactive layer as compared to at least one of said area sections with a larger areal size. Thereby, several or each of said area sections may constitute a photoactive device, in particular a photovoltaic cell or above mentioned submodule.

Advantageously, repeating arrangements of at least two of said area sections may be provided, in particular in the form of above mentioned submodules, said repeating arrangements being subsequently disposed in at least one direction of said film layer. In such a way, various zones with substantially identical properties may be provided in a continuous fabrication process. Advantageously, all photoactive area sections enclosed in one of said repeating arrangements may be bypassed by at least one of said bypass diodes and/or resistances and/or Zener diodes. This allows comparatively stable operation of the module even if portions of its surface are shaded and/or one or several single cells exhibit poor photovoltaic performance properties.

Advantageously, at least two rows of area sections may be disposed substantially parallel to each other on said film layer, wherein said differing compositional and/or structural properties of said film layer are provided for at least two of said area sections in different rows. As such, several or each of said area sections may constitute a photoactive device, in particular a photovoltaic cell or submodule. Said area sections may be in series connection along said rows and/or in parallel connection in between said rows. In this way, matching of the voltages at the MPP of said area sections of each row may be achieved.

Advantageously, said area sections in different rows may differ in their respective length in the direction of said variation of said compositional and/or structural property of said film layer. Such an arrangement may be particularly suited for voltage matching between different rows. Furthermore, said rows with shorter area sections in the direction of said variation of said compositional and/or structural property of said film layer may contain a larger number of area sections in order to achieve said voltage matching of said rows.

Advantageously, repeating arrangements of said submodules may be disposed along the length of said film so as to constitute said module, said repeating arrangement of submodules being bypassed by at least one of said bypass diodes.

The invention is described in more detail in the following description of preferred exemplary embodiments with reference to the accompanying drawings.

### BRIEF DESCRIPTION OF THE DRAWINGS

- Fig. 1: is a schematic view of a photovoltaic module comprising several submodules;
- Fig. 2: is a schematic view of a submodule of the photovoltaic module shown in Fig. 1;
- Fig. 3: is a circuit diagram representing an ideal and a real photovoltaic cell;
- Fig. 4: is a circuit diagram representing a photovoltaic module comprising several submodules;
- Fig. 5: is a schematic view of an apparatus for the fabrication of monolithically-integrated photovoltaic modules;
- Fig. 6: is a diagram representing the amount of material deposited on a deposition area by means of the apparatus shown in Fig. 5; and
- Fig. 7: is a diagram representing the corresponding material percentage composition of the deposition profile according to Fig. 6.

### DETAILED DESCRIPTION OF PREFERRED EMBODIMENTS

Subsequently, a manufacturing method and resulting monolithically integrated thin-film photovoltaic modules are described, where film patterning processes are correlated with spatial variations of film properties such as electronic, compositional, optoelectronic, or structural properties. As a result, units with homogeneous properties across their area, e.g., photovoltaic cells with homogeneous optoelectronic performance, can be created. Properties may vary from unit to unit, however. In this way, a potentially inhomogeneous large-area film or film stack can be divided into comparatively homogeneous zones. This, on the one hand, allows to improve the electricity generation performance of a module relative to the performance of a conventionally-scribed module exhibiting some inhomogeneous film properties, while on the other hand it also allows to relax the demands on the deposition sources. The latter is because inhomogeneous material deposition profiles no longer lead to degraded module performance. This is advantageous in that one may then employ less sophisticated and more robust and less expensive deposition sources while improving material utilization yield.

The determination of local film properties may be based on theoretical considerations originating from knowledge about the source properties, on analysis of experimental data gathered from prior runs, or on methods that allow the local analysis of materials properties immediately before calculating and applying the optimal patterning scheme.

In one embodiment of the invention, one or several films on a substrate are patterned such that any so-defined lowest-level submodule contains current-matched photovoltaic cells. Furthermore, such submodules connected in series and/or parallel can also be designed to be current and/or voltage matched, such that every photovoltaic cell can be operated at its maximum power point, or at least such that no photovoltaic cell under operation delivers less than 90 percent of the power it could deliver at its maximum power point (MPP).

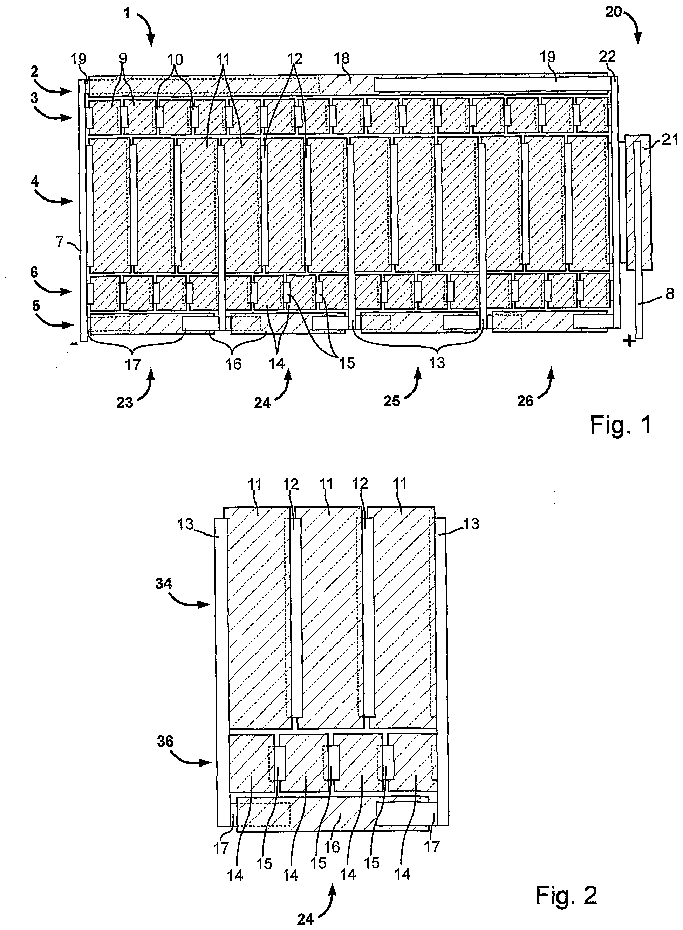

Fig. 1 depicts a photovoltaic module 1. The module 1 comprises different homogeneous zones 2-6. Zones 2-6 substantially extend parallel to each other in one longitudinal direction essentially over the whole module length and thus cover most of the module surface. Both ends of each of the zones 2-6 are connected to busbars 7, 8, corresponding to a cathode 7 and an anode 8 for a total collection of the photocurrent generated by module 1. Zones 2-6 comprise a module bypass zone 2, a first photovoltaic cell zone 3, a second photovoltaic cell zone 4, a submodule bypass zone 5, a third photovoltaic cell zone 6, and a blocking diode zone 20.

In Fig. 1, the first photovoltaic cell zone 3 comprises fifteen photovoltaic cells 9 interconnected in series via contacts 10 to a submodule 3 and constitutes a secondary power-generating submodule 3. The second photovoltaic cell zone 4 comprises twelve photovoltaic cells 11 which are series-connected via contacts 12 and 13 and constitutes a main power-generating submodule 4. The third photovoltaic cell zone 6 comprises sixteen photovoltaic cells 14 which are series-connected via contacts 15 and 13 and constitutes a second secondary power-generating submodule 6. The main power-generating submodule 4 is disposed at the center of the module 1 and its photovoltaic cells 11 are approximately six times larger compared to the substantially equally sized photovoltaic cells 9, 14, of the secondary power-generating submodule 3 and of the second secondary power-generating submodule 6 respectively. Thus, the total area covered by the main power-generating submodule 4 roughly corresponds to the summed up area covered by the other zones 2, 3, 5, 6.

The submodule bypass zone 5 is disposed below the third photovoltaic cell zone 6 and comprises four bypass diodes 16 that are interconnected in series via contacts 17 and 13.

The module bypass zone 2 comprises one bypass diode 18 extending essentially over the whole module length and being interconnected with cathode 7 and anode 8 via contacts 19. The widths of bypass diode 18 from module bypass zone 2 and bypass diodes 16 from submodule bypass zone 5 are essentially the same and roughly correspond to the side length of the essentially square shaped photovoltaic cells 9, 14, of the secondary power-generating submodules 3, 6. The end side at anode 8 is formed by a blocking diode zone 7, comprising a blocking diode 21 in which the anode busbar 8 is included and that is interconnected in series with all zones 2, 3, 4, 5, 6 via a contact 22.

The positions of the three contacts 13 define four parallel upright zones 23, 24, 25, 26 corresponding to larger parallel submodules 23, 24, 25, 26. The parallel submodules 23, 24, 25, 26 correspond to a repeating arrangement of a group of above described components. Therefore, each parallel submodule consists of three series-connected photovoltaic cells 11 from main power-generating submodule 4, four series-connected photovoltaic cells 14 from the second secondary power-generating submodule 6, and one intermediate bypass-diode 16 from submodule bypass zone 5, that are interconnected in parallel via contacts 13 at the ends of each parallel submodule 23, 24, 25, 26.

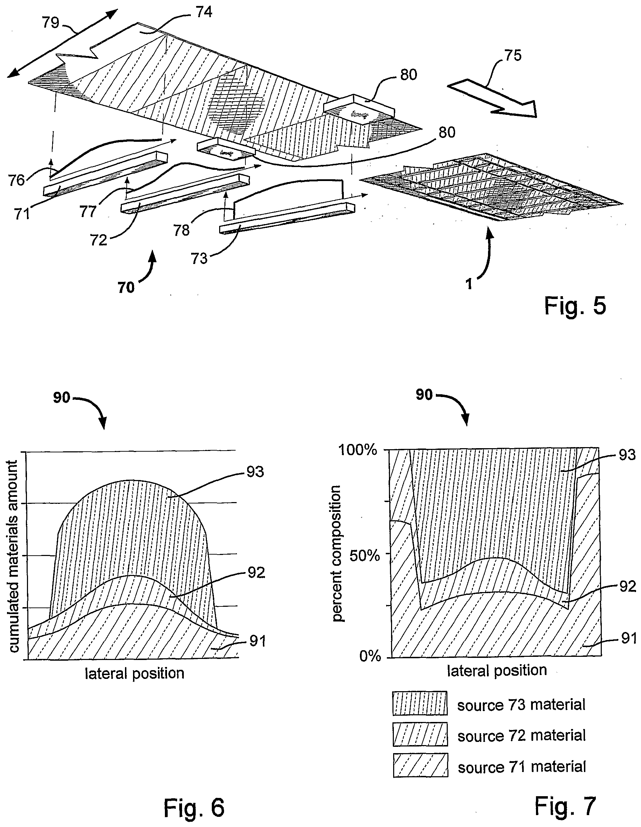

Each of the described zones 2, 3, 4, 5, 6 comprises at least one area section fabricated by application of a patterning scheme on a film layer 90 as depicted in Fig. 5 and further detailed below. Each of the described photovoltaic cells 9, 11, 14 and bypass diodes 16, 18 comprises one of these area sections which subsequently are - for simplicity reasons - denoted with the corresponding reference numeral 9, 11, 14, 16, 18. All area sections 9, 11, 14, 16, 18 in the same zone 2, 3, 4, 5, 6 substantially exhibit the same compositional and/or structural properties of film layer 90. However, area sections 9, 11, 14, 16, 18 in at least two different zones 2, 3, 4, 5, 6 exhibit different compositional and/or structural properties of film layer 90. For instance, area sections 11 differ in their film layer properties from area sections 9, 14, 16, 18 and area sections 9, 14 also differ in their film layer properties from area sections 16, 18.

Fig. 2 depicts one parallel submodule 24. The single portions of zones 4 and 6 in each parallel submodule 23, 24, 25, 26 correspond to lowest-level submodules 34, 36. Thus, the lowest-level submodules 34, 36 and a submodule bypass diode 16 are connected in parallel.

Accordingly, the zones 2, 3, 6 correspond to different rows of photoactive area sections 9, 11, 14, wherein said rows 2, 3, 5 are disposed substantially parallel to each other. Furthermore, zones 2, 5 correspond to rows consisting of one or more bypass diodes 17, 18 that are also arranged essentially in parallel with respect to rows 2, 3, 5. All area sections of photovoltaic cells 9, 11, 14 as well as the diodes 16, 18, 21 are formed from the same film layer 90 by application of the patterning scheme, i.e. their respective surface area corresponds to different area sections of the same film layer 90. Contacts 10, 12, 15, 17 are formed from a different layer that is subsequently deposited on said film layer and by applying a different patterning scheme. The different sizing of said area sections of photovoltaic cells 9, 11, 14 allows matching of voltages at their maximum power point (MPP) despite variations of film layer properties in the upright direction. The different sizing of area sections with respect to film layer variations is further exploited for the formation of components with different properties, in particular which do not serve as photovoltaic generators, e.g., diodes 16, 18, 21.

The secondary submodules 3, 6 are voltage matched to each other and to the main power-generating submodule 4. The lowest-level submodules 34, 36 are also voltage matched with respect to each other and with lowest-level submodules 34, 36 of other parallel submodules 23, 24, 25, 26. In a real embodiment, a module would typically contain more elements than shown in Fig. 1, thereby easing voltage matching between individual submodules. Furthermore, the cell proportions could be different.

It is assumed in this example depicted in Fig. 2 that the material properties of zone 6 are such that the cells in this zone have an MPP voltage that is about 75 percent lower than the MPP voltage of the cells in zone 4. Hence, both lowest-level submodules exhibit the same submodule voltage when all cells are operated at their MPP, i.e., they are voltage matched, which is ideal for the parallel connection. In this way, current generated by cells in zone 6 can be used to contribute to the total module current.

If current common state-of-the-art patterning methods were applied, this would have the disadvantage of producing larger cells compared to the advantageous structuring of cells into zones 4 and 6 according to the above described method combined with parallel connection of cells from zones 4 and 6. A further disadvantage of applying current common state-of-the-art methods would result in the operating voltage being dragged away from the local maximum power points of both zones, therefore effecting a low power output of the module.

In a further embodiment, the power output of a module is maximized, when the module contains submodules with different material properties connected in parallel. For example, with reference to Fig. 2, a submodule 36 with a lower (predicted) independent power output at its MPP is patterned to produce a different number of series connected cells so that its submodule MPP voltage at least equals the MPP voltage of the submodule 34 with superior power production properties, wherein within this restriction, the MPP voltage of secondary submodule 36 remains as closely matched to the MPP voltage of the main power producing submodule 34, as can be achieved by the described method of subdividing submodule 3, or 36, into the adequate number of series connected cells. The resulting difference in MPP voltage between main and secondary submodules will therefore be strongly reduced.

In such a way it is guaranteed that the main submodule 4 can work at or close to its MPP at all times, while the secondary submodule 36 or submodules 3 and 6 remain close to their MPP and thus contribute to overall power generation even if they are made out of material yielding inferior cells. There may be more than two submodules 34, 36 connected in parallel. In this case, the MPP voltage of the most power-generating submodule 4 is chosen and subsequently serves as reference for the MPP voltage determination of the remaining submodules 3, 6, as described above. Patterning of modules that does not consider this, for example in modules with cells spanning over inhomogeneities, suffer extensively from power loss by current flowing back through the forward-biased junctions of the zones with lowest open-circuit voltage.

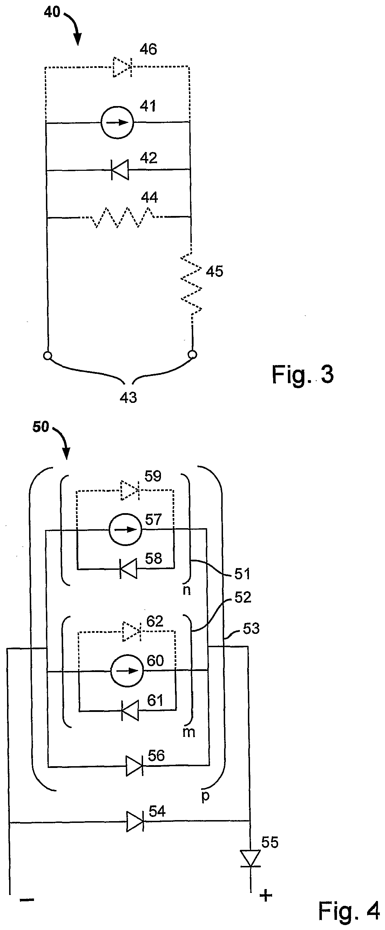

Fig. 3 depicts a representation of a photovoltaic cell 40 in a circuit diagram. In an idealized case the photovoltaic cell 40 consists of a current generator 41 and a diode 42 connected anti-parallel, i.e., the diode's forward current flows in a direction opposite to the direction of the generator's current flow. Once a voltage exceeding the diode's 42 threshold voltage exists over the photovoltaic cell terminals 43, a significant part or all of the current generated by the current generator 41 can flow back through diode 42 and hence through the photovoltaic cell. A simple equivalent circuit of a non-ideal cell includes a shunting or parallel resistance 44 and a series resistance 45 to more adequately describe a real photovoltaic cell. An optional bypass diode 46 may also be integrated in the cell design.

Fig. 4 is a circuit schematic diagram of a photovoltaic module 50 equivalent to module 1 depicted in Fig. 1. In Fig. 4, elements in brackets 51, 52, 53 are understood as being series-connected with as many repetitions as the respective bracket index n, m, p, which represents a positive integer, indicates. The represented module 50 consists of a series connection of p submodules 53, a module bypass diode 54, and a blocking diode 55 to prevent any current from flowing back through the module. Each of the p submodules 53 is a parallel connection of two lower-level submodules 51, 52, and of a submodule bypass diode 56. One of the lower-level submodules is made of a series connection of n cells represented as ideal photovoltaic cells with a current generator 57 and a diode 58 for simplicity, each connected in parallel with an optional bypass diode 59 as in Fig. 2. The other of the lower-level submodules 52 is made of a series connection of m cells with a current generator 60 and a diode 61, each connected in parallel with an optional bypass diode 62 as well.

Common patterning methods would result in an equal number of cells per submodule m and n, irrespective of the optoelectronic properties of the cells, or there would be no splitting at all into two parallel-connected submodules, i.e., n would be equal to zero. In contrast, the above-described patterning scheme suggests that the optoelectronic properties of different zones 2, 3, 4, 5, 6 of the deposited films are taken into account and patterning is performed accordingly, such that the voltage over the n cells of one submodule 51 equals the voltage over the m cells of the other submodule 52, thereby advantageously enabling all p submodules 53 to generate more electrical power as compared to common patterning methods.

In Fig. 2, an example of one of the p submodules 53 according to Fig. 4 is illustrated, where n = 3 for submodule 34 and m = 4 for submodule 36 and an additional submodule bypass diode 17 is added. Typically, m and n would stand for larger numbers than 3 or 4, e.g. of the order of 10-50. The configuration shown in Fig. 4 is one example of countless combinations of submodules, cells, and/or bypass diodes, where every submodule again may consist of one or several submodules, cells, and/or bypass diodes. The most suitable combination depends on the optoelectronic properties of the material to be patterned and the geometry of the module.

In a further embodiment, a partially shaded or damaged module is protected from significant and permanent or further damage while its power output is increased. The module is assumed to contain a zone (PV-Zener zone) where photovoltaic cells with low reverse-breakdown voltage can be created. Such photovoltaic cells correspond to a photovoltaic Zener diode, i.e., a Zener diode showing photovoltaic activity. One could also speak of a parallel connection of a Zener diode with a photovoltaic cell, where the reverse breakdown is determined by the Zener diode and the forward current flow threshold is determined by the photovoltaic cell. Patterning is performed such that in a zone, one or several submodules are generated by parallel connection with main power-generating submodules. In this way, such a submodule serves as a reverse bias protection to the module section it spans. At the same time, said submodule still yields power under illumination.

In yet another embodiment concerning the patterning scheme, thereby protecting partially shaded or damaged modules from permanent or further damage and allowing to increase their power output, bypass diodes that are either permanently shaded from irradiation, or do not generate a photocurrent when illuminated, are formed in a zone where preferably the threshold voltage is less than the threshold voltage of the zones containing the main cells. A low threshold voltage is desirable because the electric losses in case of an active bypass are proportional to the voltage drop it creates. Shading of photoactive diodes is favorable because photocurrent generated in an anti-parallel connected element is opposed to the current produced in the cells of the module, thus eliminating part of the net current and power created by the module. These properties can be achieved by depositing films with inhomogeneous composition in this zone. There are many film compositions that give rise to devices with diode behavior generating only small amounts of or no photocurrent.

Fig. 5 schematically illustrates an apparatus 70 for the fabrication of monolithically-integrated photovoltaic modules, such as module 1 depicted in Fig. 1. The apparatus comprises three material sources 71-73, an In/Ga-source 71, a Se-source 72 and a Cu-source 73, which are suited to deposit a film layer consisting of Cu(In,Ga)Se₂ on a deposition area 74. The deposition area 74 may consist of a substrate that is continuously moved in a transport direction 75 that is transverse to the respective deposition profiles 76-78 of material sources 71-73. As becomes apparent from the particular shape of each of the deposition rate profiles 76-78, the deposition rate of each of the materials is varied in a transverse direction 79 with respect to the transport direction 75. Therefore, transverse direction 79 corresponds to the upright direction of module 1 also depicted in Fig. 1. The variation of material deposition rate of sources 71-73 can be controlled by applying deposition control means 80, which are schematically illustrated on both sides of source 73 in Fig. 5.

Fig. 6 is an area chart that shows the total amount of the different materials 91-93 that are deposited on deposition area 74 in said transverse direction 79 after passing the three sources 71-73, respectively, such that a film layer 90 is formed on deposition area 74.

Fig. 7 is an area chart that shows the corresponding material percentage composition of film layer 90 in said transverse direction 79.

In order to achieve suitable film properties for bypass diode elements, which are typically very different from the film properties aimed at for photovoltaic cells, it may be necessary to influence a deposition process to induce different material properties in the bypass diode zone 2, 5 of the films. A rapid material deposition transition from cell zones to bypass zones is desirable for exploiting the largest possible part of the module with high quality cells so that a rapid spatial transition to zones with low threshold voltages for the bypass can be achieved. For example, deposition control means 80 in the form of screens, shields, or shadow masks may be employed to alter the effective deposition profiles of certain sources, as illustrated in Fig. 5.

The shading of a bypass diode on the other hand can be achieved as a post cell production step, and using bypass material similar to the cell material may be an adequate solution in this case.

The practicability of the described method and apparatus may be demonstrated on the example of a CIGS (copper-indium-gallium-diselenide) absorber based photovoltaic cell. These cells typically consist of a molybdenum back contact, on which the CIGS absorber layer, forming the p-type semiconductor, is deposited. Typically, the CIGS layer is coated by a CdS buffer layer and one or two undoped or doped ZnO layers as n-type semiconductors and as a transparent conductive window layer, serving as front contact.

The cells produced by this process show very important dependencies between copper content and photoelectric properties. More specifically, it has been measured that a standard Cu:In:Ga:Se atomic percentage composition of about 22:23:5:50 yields cells with a photovoltaic light to electricity conversion efficiency exceeding 10 percent. These cells typically show a short-circuit current density of about 30 mA/cm² and an open-circuit voltage of about 550 mV. Increasing the relative copper content reduces both short circuit current density and open circuit voltage of the cells. It is thus clear that the standard composition could be used for the main power generating elements in a module.

If for example in an evaporation process the homogeneity over the width of the entire substrate is poor, whether originating from deliberate placement of shields, from source design, or from any other intentional or unintentional reason, zones with higher copper content may exist. Since cells in these zones exhibit reduced open-circuit voltage it is preferable to create parallel submodules 2, 3, 4, 5, 6 in these zones to avoid draining the voltage away from each zone's MPP as described above. By further increasing the copper content above 24% the photocurrent becomes small or even zero while the open circuit voltage decreases to below 300 mV. Such material is well suited for shaded, or if negligible current is generated, unshaded bypass diodes as explained above. Furthermore, compositions with increased copper content can show Zener-diode behavior at voltages as low as -500 mV.

In one exemplary embodiment of the present invention related to CIGS photovoltaic cells, a small additional copper flux towards the centerline of the module in its moving direction may generate a bypass diode zone along this line that does not require shading. Furthermore, since it is in the middle of the module, the bypass diode advantageously provides the least resistive losses when the current has to be collected over the module width to be passed through the diode.

In another embodiment of the present invention related to CIGS photovoltaic cells, a copper-rich zone is created near the edges of the module where framing of the module could easily shade the diodes.

In yet a further embodiment, previously described embodiments may be combined as illustrated in Fig. 1, for example, to yield a photovoltaic module optimized for a given application, may this be lifetime energy yield, damage tolerance, process yield, manufacturing cost per kWh, manufacturing cost per Watt peak, or further demands.

Numerous alterations of the method, apparatus, and module described herein will suggest themselves to those skilled in the art. It is to be understood that the present disclosure relates to preferred embodiments of the invention which are for purposes of illustration only and are not to be construed as a limitation of the invention as defined by the claims.

## Claims

1. A method for fabricating monolithically-integrated photovoltaic modules (1, 50) comprising the steps of forming a film layer (90) on a deposition area (74) such that at least a portion of said film layer (90) constitutes a photoactive layer, applying a patterning scheme for dividing said film layer into area sections (9, 11, 14, 16, 18, 21) and providing electrically interconnected components each comprising at least one of said area sections (9, 11, 14, 16, 18, 21), wherein at least one compositional and/or structural property, material percentage composition and/or thickness, of said film layer (90) is varied over said deposition area (74), and said patterning scheme is applied in such a way
- that at least one of said film layer variations in at least one of said area sections (9, 11, 14, 16, 18, 21) is reduced with respect to the corresponding film layer variation over said deposition area (74) for providing at least two of said area sections (9, 11, 14, 16, 18, 21) with substantially differing compositional and/or structural properties, and
- that said deposition area is subdivided into area zones (2, 3, 4, 5, 6) with different compositional and/or structural properties of said film layer, at least one of said area zones (2, 3, 4, 5, 6) comprising area sections (9, 11, 14, 16, 18, 21) with essentially the same compositional and/or structural properties of said film layer,
**characterized in that** at least one of said compositional and/or structural properties of said film layer (90) is varied such that in a region comprising at least one of said area zones (2, 3, 4, 5, 6) photovoltaic properties are generated that are degraded with respect to the photovoltaic properties of another area zone (2, 3, 4, 5, 6), for providing at least one bypass diode (16, 18, 54, 56, 59, 62) and/or resistor and/or Zener diode comprising at least a portion of said film layer (90) on at least one of said area sections (9, 11, 14, 16, 18, 21) in said area zone (2, 3, 4, 5, 6) of degraded photovoltaic properties after applying of said patterning scheme, such that at least two of said components including said bypass diode (16, 18, 54, 56, 59, 62) and/or resistor and/or Zener diode exhibit substantially differing current-voltage characteristics, a different diode threshold voltage and/or different reverse breakdown voltage, wherein said at least two components are interconnected in parallel,
whereby said forming of a film layer (90) comprises evaporating and depositing material on said deposition area from at least one material source (71, 72, 73) provided with deposition controlling means (80) in the form of screens, shields, or shadow masks, configured to be applied on said material source or sources (71, 72, 73) to control at least one of said film layer (90) variations such that degraded photovoltaic properties can be generated in at least one region of said film layer (90), wherein said deposition area (74) is moved with respect to said material source (71, 72, 73) and said varying of at least one compositional and/or structural property of said film layer (90) is carried out transverse to the respective moving direction (75).

2. The method according to claim 1, **characterized in that** at least one of said components is provided by a submodule comprising a series connection of photovoltaic cells each comprising one of said area sections (9, 11, 14, 16, 18, 21) in said at least one area zone (2, 3, 4, 5, 6).

3. The method according to claim 2, **characterized in that** said patterning scheme is applied in such a way that area sections (9, 11, 14, 16, 18, 21) in at least two of said different area zones (2, 3, 4, 5, 6) are provided with a different geometrical property comprising at least one of size, shape, orientation, and areal number such that at least two of said submodules exhibit a substantially equal voltage value at their maximum power point.

4. The method according to at least one of claims 1 to 3, **characterized in that** said different current-voltage characteristics comprises at least one of the current value at a substantially equal voltage value at the maximum power point, the open circuit voltage, the reverse breakdown voltage, and the diode threshold voltage.

5. The method according to at least one of claims 1 to 4, **characterized in that** said current-voltage characteristics of at least two of said components differs by a factor of at least 2 percent, more preferred by a factor of at least 5 percent, and most preferred by a factor of at least 10 percent.

6. The method according to at least one of claims 1 to 5, **characterized in that** the compositional ratio of Cu is varied in said film layer in a range of 0.6 to 0.9 with respect to group 13 material of the periodic table of chemical elements as defined by the International Union of Pure and Applied Chemistry, in particular In, Ga, or Al.

7. The method according to at least one of claims 1 to 6, **characterized in that** said forming of a film layer (90) comprises evaporating and depositing material on said deposition area from at least one material source (71, 72, 73), wherein said deposition area (74) is moved roll-to-roll with respect to said material source (71, 72, 73) and said varying of at least one compositional and/or structural property of said film layer (90) is carried out transverse to the respective moving direction (75).

8. The method according to at least one of claims 1 to 7, **characterized in that** said forming of a film layer (90) comprises evaporating and depositing materials on said deposition area from separated material sources (71, 72, 73), wherein the deposition rate of at least one of said sources (71, 72, 73) is varied over said deposition area (74) such that said varying of compositional properties comprises varying of a percentage composition and/or an absolute quantity of at least one of said deposited materials.

9. An apparatus for the fabrication of monolithically-integrated photovoltaic modules (1, 50), for executing the method according to at least one of claims 1 to 8, comprising at least one evaporation source (71, 72, 73), in particular at least one of Cu, Ag, In, Ga, Al, S, Se and Te sources, for forming a film layer (90) on a deposition area (74), at least a portion of said film layer (90) constituting a photoactive layer, and a patterning means for dividing said film layer (90) into electrically interconnectable area sections (9, 11, 14, 16, 18, 21), wherein said evaporation source (71, 72, 73) is adapted for depositing said film layer (90) with at least one compositional and/or structural property, material percentage composition and/or thickness, varying over said deposition area (74) according to a particular shape of a deposition rate profile (76, 77, 78),
**characterized in that** said evaporation source (71, 72, 73) is provided with deposition controlling means (80) in the form of screens, shields, or shadow masks, configured to be applied on said material source or sources (71, 72, 73) to control at least one of said film layer (90) variations such that degraded photovoltaic properties can be generated in at least one region of said film layer (90), and said patterning means is adapted for dividing said film layer (90) into at least two of said area sections (9, 11, 14, 16, 18, 21) with substantially differing compositional and/or structural properties such that at least two of said components exhibit substantially differing current-voltage characteristics, a different diode threshold voltage and/or different reverse breakdown voltage, and that at least one of said components is provided in said region of degraded photovoltaic properties as a bypass diode (16, 18, 54, 56, 59, 62) and/or resistor and/or Zener diode, wherein said apparatus is adapted for interconnecting said at least two components in parallel.

10. A photovoltaic module produced with the method according to at least one of claims 1 to 8, comprising at least one film layer (90), at least a portion of said film layer (90) constituting a photoactive layer, said film layer (90) being divided into area sections (9, 11, 14, 16, 18, 21), and electrically interconnected components each comprising at least one of said area sections (9, 11, 14, 16, 18, 21), wherein at least two of said area sections (9, 11, 14, 16, 18, 21) of said film layer (90) are provided with substantially differing compositional and/or structural properties, material percentage composition and/or thickness, and said film layer is divided into area zones (2, 3, 4, 5, 6) with different compositional and/or structural properties of said film layer, at least one of said area zones (2, 3, 4, 5, 6) comprising area sections (9, 11, 14, 16, 18, 21) with essentially the same compositional and/or structural properties of said film layer,
wherein in at least one of said area zones (2, 3, 4, 5, 6) photovoltaic properties are provided that are degraded with respect to the photovoltaic properties of another area zone (2, 3, 4, 5, 6), wherein at least one of said components is provided as a bypass diode (16, 18, 54, 56, 59, 62) and/or resistor and/or Zener diode comprising at least a portion of said film layer (90) in said area zone (2, 3, 4, 5, 6) of degraded photovoltaic properties, such that at least two of said components including said bypass diode (16, 18, 54, 56, 59, 62) and/or resistor and/or Zener diode exhibit substantially differing current-voltage characteristics, a different diode threshold voltage and/or different reverse breakdown voltage, said at least two components being interconnected in parallel,
**characterized in that** at least two of said area sections (9, 11, 14, 16, 18, 21) are provided with a different geometrical property comprising at least one of size, shape, orientation, and areal number.

11. The photovoltaic module according to claim 10, **characterized in that** at least one of said components is provided by a submodule comprising a series connection of photovoltaic cells each comprising one of said area sections (9, 11, 14, 16, 18, 21) in said at least one area zone (2, 3, 4, 5, 6).

## Patentansprüche

1. Verfahren zur Herstellung von monolithisch integrierten Fotovoltaikmodulen (1, 50), umfassend die Schritte des Bildens einer Filmschicht (90) auf einem Abscheidungsbereich (74), so dass mindestens ein Teil der Filmschicht (90) ein fotoaktives Element bildet, mit Aufbringen eines Musterschemas zum Aufteilen der Filmschicht in Flächenabschnitte (9, 11, 14, 16, 18, 21) und dem bereitstellen von elektrisch miteinander verbundenen Bauteilen, die jeweils mindestens einen der Flächenabschnitte (9, 11, 14, 16,18, 21) umfassen, wobei mindestens eine Zusammensetzung und / oder Struktureigenschaft, insbesondere eine prozentuale Materialzusammensetzung und / oder -Dicke, der Filmschicht (90) über den Abscheidungsbereich (74) variiert wird und das Musterungsschema auf diese Weise angewendet
- dass mindestens eine der Filmschichtvariationen in mindestens einem der Flächenabschnitte (9, 11, 14, 16, 18, 21) gegenüber der entsprechenden Filmschichtvariation über der Abscheidefläche (74) zum Bereitstellen reduziert ist, mindestens zwei der Flächenabschnitte (9, 11, 14, 16, 18, 21) mit wesentlich unterschiedlichen Zusammensetzungs- und / oder strukturellen Eigenschaften und
- dass die Abscheidefläche in Flächenbereiche (2, 3, 4, 5, 6) mit unterschiedlichen Zusammensetzungs- und / oder Struktureigenschaften der Folienschicht unterteilt ist, wobei mindestens einer der Flächenbereiche (2, 3, 4, 5, 6) Flächenabschnitte (9, 11, 14, 16, 18, 21) mit im Wesentlichen gleichen zusammengesetzten und / oder strukturellen Eigenschaften der Folienschicht aufweist, **dadurch gekennzeichnet, dass** mindestens eine der zusammengesetzten und / oder strukturellen Eigenschaften der Folienschicht (90) derart variiert wird, dass in einem Bereich, der mindestens eine der Flächenzonen (2, 3, 4, 5, 6) umfasst, fotovoltaische Eigenschaften vorliegen erzeugt, die bezüglich der fotovoltaischen Eigenschaften einer anderen Flächenzone (2, 3, 4, 5, 6) verschlechtert sind, um mindestens eine Bypass Diode (16, 18, 54, 56, 59, 62) und / oder Widerstand vorzusehen und / oder eine Zenerdiode, die mindestens einen Teil der Filmschicht (90) auf mindestens einem der Flächenabschnitte (9, 11, 14, 16, 18, 21) in der Flächenzone (2, 3, 4, 5, 6) aufweist, den Abbau der fotovoltaische Eigenschaften nach dem Anwenden des Musterungsschemas aufweisen, so dass mindestens zwei der Komponenten, die die Überbrückungsdiode (16, 18, 54, 56, 59, 62) und / oder den Widerstand und / oder die Zenerdiode enthalten, im Wesentlichen unterschiedliche Strom-Spannungs-Eigenschaften aufweisen, eine unterschiedliche DiodenSchwellenspannung und / oder eine unterschiedliche Sperrspannung, wobei die mindestens zwei Komponenten parallel ineinander geschaltet sind,
wobei das Ausbilden einer Filmschicht (90) das Verdampfen und Abscheiden von Materialien auf dem Abscheidungsbereich von getrennten Materialquellen (71, 72, 73) umfasst, die mit Abscheidungssteuermitteln (80), Sieben und / oder Schilden und / oder Schattenmasken versehen sind, konfiguriert um auf die Materialquelle oder -quellen (71, 72, 73) aufgebracht zu werden, um mindestens eine der Filmschichten (90) zu steuern, wobei der Abscheidungsbereich (74) in Bezug auf die Materialquelle (71, 72, 73) bewegt wird und das Variieren mindestens einer Zusammensetzung und / oder Struktureigenschaft der Folienschicht (90) quer zur jeweiligen Bewegungsrichtung (75) erfolgt.

2. Verfahren nach Anspruch 1 **dadurch gekennzeichnet, dass** mindestens eine der Komponenten durch ein Teilmodul bereitgestellt wird, das eine Reihenschaltung von Fotovoltaikzellen umfasst, die jeweils einen der Flächenabschnitte (9, 11, 14, 16, 18, 21) umfassen, in der mindestens einen genannten Flächenzone (2, 3, 4, 5, 6).

3. Verfahren nach Anspruch 2, **dadurch gekennzeichnet, dass** das Musterungsschema so angewendet wird, dass Flächenabschnitte (9, 11, 14, 16, 18, 21) in mindestens zwei der unterschiedlichen Flächenzonen (2, 3, 4, 5, 6) liegen, mit einer unterschiedlichen geometrischen Eigenschaft versehen sind, die mindestens eine der Größen, Formen, Orientierungen und Flächenzahlen umfasst, so dass mindestens zwei der Submodule an ihrem maximalen Leistungspunkt einen im Wesentlichen gleichen Spannungswert aufweisen.

4. Verfahren nach mindestens einem der Ansprüche 1 bis 3, **dadurch gekennzeichnet, dass** die unterschiedlichen Strom-Spannungs-Kennlinien mindestens einen der Stromwerte bei einem im Wesentlichen gleichen Spannungswert am maximalen Leistungspunkt, der Leerlaufspannung, umfassen Durchbruchspannung in Sperrrichtung und die Diodenschwellenspannung aufweisen.

5. Verfahren nach mindestens einem der Ansprüche 1 bis 4, **dadurch gekennzeichnet, dass** sich die Strom-Spannungs-Eigenschaften von mindestens zwei der Komponenten um einen Faktor von mindestens 2 Prozent, noch besser um einen Faktor von mindestens 5 Prozent und am meisten bevorzugt um einen Faktor von mindestens 10 Prozent unterscheiden.

6. Verfahren nach mindestens einem der Ansprüche 1 bis 5, **dadurch gekennzeichnet, dass** das Zusammensetzungsverhältnis von Cu in der Filmschicht in einem Bereich von 0,6 bis 0,9 in Bezug auf Material der Gruppe 13 des Periodensystems der chemischen Elemente variiert wird, definiert durch die Internationale Union für Reine und Angewandte Chemie, insbesondere In, Ga oder Al.

7. Verfahren nach mindestens einem der Ansprüche 1 bis 6, **dadurch gekennzeichnet, dass** das formen einer Filmschicht (90) mit Verdampfen und Abscheiden von Material auf dem Abscheidungsbereich von mindestens einer Materialquelle (71, 72, 73) umfasst, wobei der Ablagerungsbereich (74) in Bezug auf die Materialquelle (71, 72, 73) von Rolle zu Rolle bewegt wird und das Variieren von mindestens einer Zusammensetzungs- und / oder Struktureigenschaft der Filmschicht (90) ausgeführt wird, quer zur jeweiligen Bewegungsrichtung (75).

8. Verfahren nach mindestens einem der Ansprüche 1 bis 7, **dadurch gekennzeichnet, dass** das Formen einer Filmschicht (90) mit Verdampfen und Abscheiden von Materialien auf dem Abscheidungsbereich aus getrennten Materialquellen (71, 72, 73) umfasst, wobei die Abscheidungsrate über die Abscheidungsfläche von mindestens einer der Quellen (71, 72, 73, 74) derart variiert, dass das Variieren der Zusammensetzungseigenschaften, das Variieren einer prozentualen Zusammensetzung und / oder einer absoluten Menge von mindestens einer der genannten hinterlegte Materialien umfasst.

9. Vorrichtung zur Herstellung von monolithisch integrierten Fotovoltaikmodulen (1, 50), insbesondere zur Durchführung des Verfahrens nach mindestens einem der Ansprüche 1 bis 8, mit mindestens einer Verdampfungsquelle (71, 72, 73). Insbesondere mindestens eine der Quellen Cu, Ag, In, Ga, AI, S, Se und Te zur Bildung einer Filmschicht (90) auf einem Abscheidungsbereich (74), wobei mindestens ein Teil der Filmschicht (90) das Formen einer fotoaktiven Schicht und eines Strukturierungsmittels zum Unterteilen der Filmschicht (90) in elektrisch miteinander verbindbare Flächenabschnitte (9, 11, 14, 16, 18, 21), für die die Verdampfungsquelle (71, 72, 73) ausgelegt ist und das abscheiden der Filmschicht (90) mit mindestens einer zusammengesetzten und / oder strukturellen Eigenschaft, insbesondere einer prozentualen Materialzusammensetzung und / oder -dicke, die über den Abscheidungsbereich (74) gemäß einer bestimmten Form eines Abscheidungsratenprofils (76, 77, 78) variiert,
**dadurch gekennzeichnet, dass** die Verdampfungsquelle (71, 72, 73) mit Ablagerungssteuermitteln (80), Sieben und / oder Schilden und / oder Schattenmasken versehen ist, die konfiguriert sind, um auf die Materialquelle oder -quellen (71, 72, 73) aufgebracht zu werden, um wenigstens eine der Variationen der Filmschicht (90) so zu steuern, dass sich abbauende fotovoltaische Eigenschaften in wenigstens einem Bereich der Filmschicht (90) erzeugt werden können, und das Strukturierungsmittel zum Aufteilen der Filmschicht (90) in mindestens zwei der Flächenabschnitte (9, 11, 14, 16, 18, 21) mit wesentlich unterschiedlichen Zusammensetzungs- und / oder Struktureigenschaften, so dass mindestens zwei der Bauelemente wesentlich unterschiedliche Strom-Spannungs-Eigenschaften aufweisen, eine unterschiedliche Diodenschwellenspannung und / oder unterschiedliche Sperrspannung, und dass mindestens eine der genannten Komponenten in dem genannten Bereich sich abbauender fotovoltaischer Eigenschaften als Bypassdiode (16, 18, 54, 56, 59, 62) und / oder Widerstand und / oder Zenerdiode vorgesehen ist, wobei die Vorrichtung dazu geeignet ist, die mindestens zwei Komponenten parallel zu verbinden.

10. Fotovoltaikmodul, hergestellt mit dem Verfahren nach mindestens einem der Ansprüche 1 bis 8, umfassend mindestens eine Filmschicht (90), wobei mindestens ein Teil der Filmschicht (90) eine fotoaktive Schicht bildet, wobei die Filmschicht (90) in Flächenabschnitte (9, 11, 14, 16, 18, 21) und elektrisch miteinander verbundene Bauteile mit jeweils mindestens einem der Flächenabschnitte (9, 11, 14, 16, 18, 21) unterteilt sind, wobei bei Mindestens zwei der Flächenabschnitte (9, 11, 14, 16, 18, 21) der Folienschicht (90) mit wesentlich unterschiedlichen Zusammensetzungs- und / oder Struktureigenschaften, prozentualer Materialzusammensetzung und / oder -dicke und die Folienschicht in Flächenzonen unterteilt ist (2, 3, 4, 5, 6), mit unterschiedlichen Zusammensetzungs- und / oder Struktureigenschaften der Folienschicht, wobei mindestens eine der Flächenzonen (2, 3, 4, 5, 6) Flächenabschnitte aufweist (9, 11, 14, 16, 18, 21) mit im Wesentlichen den gleichen zusammengesetzten und / oder strukturellen Eigenschaften der Filmschicht, wobei in mindestens einer der Flächenzonen (2, 3, 4, 5, 6) fotovoltaische Eigenschaften vorgesehen sind, die sich gegenüber den fotovoltaischen Eigenschaften einer anderen Flächenzone (2, 3, 4, 5, 6) abbauen, wobei Mindestens eine der Komponenten als Bypass-Diode (16, 18, 54, 56, 59, 62) und / oder Widerstand und / oder Zenerdiode vorgesehen ist, die mindestens einen Teil der Filmschicht (90) in der Flächenzone umfasst (2, 3, 4, 5, 6) abgebaute fotovoltaische Eigenschaften aufweisen, so dass mindestens zwei der genannten Bauelemente die genannte Bypassdiode (16, 18, 54, 56, 59, 62) und / oder Widerstand und / oder Zenerdiode umfassen, wesentlich unterschiedliche Strom-Spannungs-Eigenschaften aufweisen, insbesondere eine unterschiedliche DiodenSchwellenspannung und / oder eine unterschiedliche Sperrspannung, wobei mindestens zwei Komponenten parallel geschaltet sind, dass zumindest zwei der genannten Flächenabschnitte (9, 11, 14, 16, 18, 21) mit einer anderen geometrischen Eigenschaft bereitgestellt werden, mindestens vergleichbar in Größe, Form, Orientierung und die Flächennummer.

11. Fotovoltaikmodul nach Anspruch 10, dass mindestens eine der Komponenten durch ein Teilmodul gekennzeichnet ist, das eine vergleichbaren Reihenschaltung von fotovoltaischen Zellen aufweist, die jeweils mindestens einen der genannten Flächenabschnitte (9, 11, 14, 16, 18, 21) in der Flächenzone (2, 3, 4, 5, 6) umfasst.

## Revendications

1. Procédé de fabrication de modules photovoltaïques monolithiquement intégrés (1, 50) comprenant les étapes de
formation d'une couche de film (90) sur une zone de déposition (74) de telle sorte qu'au moins une partie de ladite couche de film (90) constitue une couche photoactive, d'application d'un motif de partitionnement pour diviser ladite couche de film en sections de surface (9, 11, 14, 16, 18, 21) et
fournir des composants électriquement interconnectés comprenant chacun au moins une desdites sections de surface (9, 11, 14, 16, 18, 21)
dans lequel au moins une propriété de composition et / ou de structure, en particulier la composition en pourcentage de matériau et / ou l'épaisseur, de ladite couche de film (90) varie sur ladite zone de déposition (74), et ledit schéma de configuration est appliqué de telle manière
- qu'au moins une desdites variations de couche de film dans au moins une desdites sections de surface (9, 11, 14, 16, 18, 21) est réduite par rapport à la variation de couche de film correspondante sur ladite zone de déposition (74) pour fournir au moins deux desdites sections de surface (9, 11, 14, 16, 18, 21) avec des propriétés de composition et / ou de structure sensiblement différentes, et
- que ladite zone de déposition est subdivisée en aires de zone (2, 3, 4, 5, 6) avec différentes propriétés de composition et / ou de structure de ladite couche de film, au moins une desdites aires de zone (2, 3, 4, 5, 6) comprenant des sections de surface (9, 11, 14, 16, 18, 21) ayant essentiellement les mêmes propriétés de composition et / ou de structure de ladite couche de film,
**caractérisé en ce qu'**au moins une desdites propriétés de composition et / ou de structure de ladite couche de film (90) varie de telle sorte que dans une région comprenant au moins une desdites aires de zone (2, 3, 4, 5, 6) les propriétés photovoltaïques sont générés dégradés par rapport aux propriétés photovoltaïques d'une autre aire de zone (2, 3, 4, 5, 6), pour fournir au moins une diode de dérivation (16, 18, 54, 56, 59, 62) et / ou une résistance et / ou une diode Zener comprenant au moins une partie de ladite couche de film (90) sur au moins une desdites sections de surface (9, 11, 14, 16, 18, 21) dans ladite aire de zone (2, 3, 4, 5 , 6) de propriétés photovoltaïques dégradées après application dudit motif de partitionnement, de sorte qu'au moins deux desdits composants comprenant ladite diode de dérivation (16, 18, 54, 56, 59, 62) et / ou la résistance et / ou la diode Zener présentent sensiblement des caractéristiques courant-tension différentes, une tension de seuil de diode différente et / ou une tension de claquage inverse différente, dans lequel lesdits au moins deux composants sont interconnectés en parallèle,
dans lequel ladite formation d'une couche de film (90) comprend l'évaporation et le dépôt de matériaux sur ladite zone de déposition à partir de sources de matériau séparées (71, 72, 73), pourvues de moyens de contrôle de déposition (80), d'écrans et / ou de blindages et / ou de masques, configurés pour être appliqués sur ladite ou lesdites sources de matériau (71, 72, 73) pour contrôler au moins une de ladite couche de film (90), dans lequel ladite zone de déposition (74) est déplacée par rapport à ladite source de matériau (71, 72 , 73) et ladite variation d'au moins une propriété de composition et / ou de structure de ladite couche de film (90) est effectuée transversalement à la direction de déplacement respective (75).

2. Procédé selon la revendication 1, **caractérisé en ce qu'**au moins un desdits composants est fourni par un sous-module comprenant une connexion en série de cellules photovoltaïques comprenant chacune une desdites sections de surface (9, 11, 14, 16, 18, 21) dans ladite au moins une aire de zone (2, 3, 4, 5, 6).

3. Procédé selon la revendication 2, **caractérisé en ce que** ledit schéma de configuration est appliqué de telle sorte que des sections de surface (9, 11, 14, 16, 18, 21) dans au moins deux desdites aires de zone différentes (2, 3 , 4, 5, 6) sont dotées d'une propriété géométrique différente comprenant au moins l'une parmi la taille, la forme, l'orientation et la valeur surfacique de telle sorte qu'au moins deux desdits sous-modules présentent une valeur de tension sensiblement égale à leur point de puissance maximale.

4. Procédé selon au moins l'une des revendications 1 à 3, **caractérisé en ce que** lesdites caractéristiques courant-tension différentes comprennent au moins l'une de la valeur de courant à une valeur de tension sensiblement égale au point de puissance maximale, la tension de circuit ouvert, la tension de claquage inverse et la tension de seuil de la diode.

5. Procédé selon au moins l'une des revendications 1 à 4, **caractérisé en ce que** lesdites caractéristiques courant-tension d'au moins deux desdits composants diffèrent d'un facteur d'au moins 2 pour cent, préférentiellement d'un facteur d'au moins 5 pour cent et plus préférentiellement d'un facteur d'au moins 10 pour cent.

6. Procédé selon au moins l'une des revendications 1 à 5, **caractérisé en ce que** le rapport de composition de Cu varie dans ladite couche de film dans une plage de 0,6 à 0,9 par rapport au matériau du groupe 13 du tableau périodique des éléments chimiques comme définis par l'Union internationale de chimie pure et appliquée, en particulier In, Ga ou Al.

7. Procédé selon au moins l'une des revendications 1 à 6, **caractérisé en ce que** ladite formation d'une couche de film (90) comprend l'évaporation et la déposition de matériau sur ladite zone de déposition à partir d'au moins une source de matériau (71, 72, 73), dans lequel ladite zone de déposition (74) est déplacée d'un rouleau à l'autre par rapport à ladite source de matériau (71, 72, 73) et ladite variation d'au moins une propriété de composition et / ou de structure de ladite couche de film (90) est effectuée transversalement à la direction de déplacement respective (75).

8. Procédé selon au moins l'une des revendications 1 à 7, **caractérisé en ce que** ladite formation d'une couche de film (90) comprend l'évaporation et le déposition de matériaux sur ladite zone de déposition à partir de sources de matériau séparées (71, 72, 73), dans lesquels le taux de déposition d'au moins une desdites sources (71, 72, 73) varie sur ladite zone de déposition (74) de telle sorte que ladite variation des propriétés de composition comprend la variation d'une composition en pourcentage et / ou d'une quantité absolue d'au moins l'un desdits matériaux déposés.

9. Appareil de fabrication de modules photovoltaïques monolithiquement intégrés (1, 50), notamment pour exécuter le procédé selon au moins l'une des revendications 1 à 8 , comprenant au moins une source d'évaporation (71, 72, 73), en particulier au moins une source de l'un de Cu, Ag, In, Ga, Al, S, Se et Te, pour former une couche de film (90) sur une zone de déposition (74), au moins une partie de ladite couche de film (90) constituant une couche photoactive, et un moyen de partitionnement pour diviser ladite couche de film (90) en sections de surface électriquement interconnectables (9, 11, 14, 16, 18, 21), dans lequel ladite source d'évaporation (71, 72, 73) est adaptée pour déposer ladite couche de film (90) avec au moins une propriété de composition et / ou de structure, en particulier une composition et / ou une épaisseur de matériau, variant sur ladite zone de dépôt (74) selon une forme particulière d'un profil de vitesse de dépôt (76, 77 , 78),
**caractérisé en ce que** ladite source d'évaporation (71, 72, 73) est pourvue de moyens de contrôle de déposition (80), d'écrans et / ou de blindages et / ou de masques, configurés pour être appliqués sur ladite ou lesdites sources de matériau (71, 72, 73) pour contrôler au moins une des variations de ladite couche de film (90) de sorte que des propriétés photovoltaïques dégradées peuvent être générées dans au moins une région de ladite couche de film (90), et lesdits moyens de configuration sont adaptés pour diviser ladite couche de film (90) en au moins deux desdites sections de surface (9, 11, 14, 16, 18, 21) avec des propriétés de composition et / ou de structure sensiblement différentes de sorte qu'au moins deux desdits composants présentent des caractéristiques courant-tension sensiblement différentes, une tension de seuil de diode différente et / ou une tension de claquage inverse différente, et qu'au moins un desdits composants est prévu dans ladite région de propriétés photovoltaïques dégradées en tant que diode de dérivation (16, 18, 54, 56, 59, 62) et / ou résistance et / ou diode Zener, dans lequel ledit appareil est adapté pour interconnecter lesdits au moins deux composants en parallèle.

10. Module photovoltaïque réalisé avec le procédé selon au moins l'une des revendications 1 à 8, comprenant au moins une couche de film (90), au moins une partie de ladite couche de film (90) constituant une couche photoactive, ladite couche de film (90) étant divisée en sections de surface (9, 11, 14, 16, 18, 21) et composants électriquement interconnectés comprenant chacun au moins une desdites sections de surface (9, 11, 14, 16, 18, 21), dans lequel au moins au moins deux desdites sections de surface (9, 11, 14, 16, 18, 21) de ladite couche de film (90) présentent des propriétés de composition et / ou de structure sensiblement différentes, une composition en pourcentage de matériau et / ou une épaisseur, et ladite couche de film est divisé en aires de zone (2, 3, 4, 5, 6) avec différentes propriétés de composition et / ou de structure de ladite couche de film, au moins une desdites aires de zone (2, 3, 4, 5, 6) comprenant des sections de surface (9, 11, 14, 16, 18, 21) avec essentiellement les mêmes propriétés de composition et / ou de structure de ladite couche de film,
dans lequel dans au moins une desdites aires de zones (2, 3, 4, 5, 6) des propriétés photovoltaïques sont fournies qui sont dégradées par rapport aux propriétés photovoltaïques d'une autre aire de zone (2, 3, 4, 5, 6), dans lesquelles au moins l'un desdits composants est prévu comme diode de dérivation (16, 18, 54, 56, 59, 62) et / ou résistance et / ou diode Zener comprenant au moins une partie de ladite couche de film (90) dans ladite aire de zone (2, 3, 4, 5, 6) de propriétés photovoltaïques dégradées, telles qu'au moins deux desdits composants comprenant ladite diode de dérivation (16, 18, 54, 56, 59, 62) et / ou résistance et / ou diode Zener présentent des caractéristiques courant-tension sensiblement différentes, en particulier une tension de seuil de diode différente et / ou une tension de claquage inverse différente, lesdits au moins deux composants étant interconnectés en parallèle, **caractérisé en ce qu'**au moins deux desdites sections de surface (9, 11, 14, 16, 18, 21) sont pourvues d'une propriété géométrique différente comprenant au moins l'une de taille, de forme, d'orientation et de valeur surfacique.

11. Module photovoltaïque selon la revendication 10, **caractérisé en ce qu'**au moins un desdits composants est fourni par un sous-module comprenant une connexion en série de cellules photovoltaïques comprenant chacune une desdites sections de surface (9, 11, 14, 16, 18 , 21) dans ladite au moins une aire de zone (2, 3, 4, 5, 6).
